# EUROPÄISCHE PATENTSCHRIFT

(11) **EP 0 590 191 B1**
(45) Veröffentlichungstag und Bekanntmachung des Hinweises auf die Patenterteilung: **12.08.1998**
(21) Anmeldenummer: 92116745.8
(22) Anmeldetag: 30.09.1992
(51) Int. Cl.: H03D 7/12

(54) **Anordnung zur Frequenzumsetzung**
Circuit for frequency conversion
Circuit pour conversion de fréquence

(43) Veröffentlichungstag der Anmeldung: 06.04.1994
(73) Patentinhaber: SIEMENS AKTIENGESELLSCHAFT, 80333 München (DE)
(72) Erfinder: Zimmermann, Walter, Ing.-grad., W-8250 Dorfen (DE)

(56) Entgegenhaltungen:
- EP-A- 87 336
- EP-A- 203 895
- PATENT ABSTRACTS OF JAPAN vol. 11, no. 122 (E-500)(2569) 16. April 1987 & JP-A-61 269 502 ( TOSHIBA CORP. ) 28. November 1986

## Beschreibung

Die Erfindung betrifft eine Anordnung zur Frequenzumsetzung eines Eingangssignals der Frequenz f₁ mit einem Oszillatorsignal der Frequenz f₂ zu einem Zwischenfreqenzsignal f₃ gemäß dem Oberbegriff des Patentanspruches 1.

Bei derartigen Anordnungen wird im Allgemeinen ein Eingangssignal mit einem Oszillatorsignal über eine nichtlineare Kennlinie derart gesteuert, dass als Mischergebnis u. a. das gewünschte Zwischenfrequenzsignal entsteht. Es gibt eine Vielzahl von Anordnungen bzw. Mischerprinzipien, die dies bewerkstelligen.

Aus der europäischen Offenlegungsschrift EP 0 203 895 ist beispielsweise ein Signalmischer für Mikrowellensysteme bekannt, der einen Feldeffekttransistor aufweist. Dieser bekannte Mischer bietet eine hohe Konversionsverstärkung bei gleichzeitig geringer Rauschzahl und minimalem Schaltungsaufwand.

Der Erfindung liegt die Aufgabe zu Grunde, eine Anordnung zur Frequenzumsetzung der eingangs genannten Art mit hoher Intermodulationsfestigkeit bei gleichzeitig geringem Leistungsbedarf zu schaffen.

Diese Aufgabe wird erfindungsgemäß durch eine Anordnung zur Frequenzumsetzung mit den Merkmalen des Anspruchs 1 gelöst.

Vorteilhafte Ausgestaltungen bzw. Weiterbildungen der Erfindung sind Gegenstand zusätzlicher Ansprüche.

Die mit der Erfindung erzielten Vorteile bestehen insbesondere darin, dass eine sehr große Intermodulationsfestigkeit der Gesamtanordnung erreicht wird. Der Eingangssignal- und der Zwischenfrequenzsignal-Anschluss sind niederohmig (50 Ohm bis 100 Ohm) und unsymmetrisch. Von Vorteil ist der geringe Leistungsverbrauch der Anordnung, der beispielsweise bei nur 300mW liegt. Zudem wird ein großer zulässiger Betriebsspannungsbereich von ungefähr 2,5V bis 7V und ein großer zulässiger L.O.-(Local Oscillator-)Pegelbereich für optimalen Betrieb erzielt. Von weiterem Vorteil ist die hohe Stabilität der Anordnung, d.h. es tritt keine Schwingneigung auf. Zudem zeichnet sich die passive Schaltermischstufe durch geringe Mischverluste aus. Die Anordnung besitzt einen sehr hohen Mischwirkungsgrad. Das Mischerprinzip ist anwendbar für Frequenzen vom NF-Bereich bis in den hohen GHz-Bereich. Der Mischer ist rauscharm. Der Mischer kann problemlos und rückwirkungsarm am Ein- und/oder Ausgang mit Verstärkern, Transimpedanzverstärkern beschaltet werden.

Anhand eines in der Figur der Zeichnung dargestellten Ausführungsbeispiels wird die Erfindung im folgenden näher erläutert.
Es zeigen
- FIG 1: eine Prinzipdarstellung der Schaltungsanordnung und
- FIG 2: ein Scnaltungsbeispiel der Anordnung.

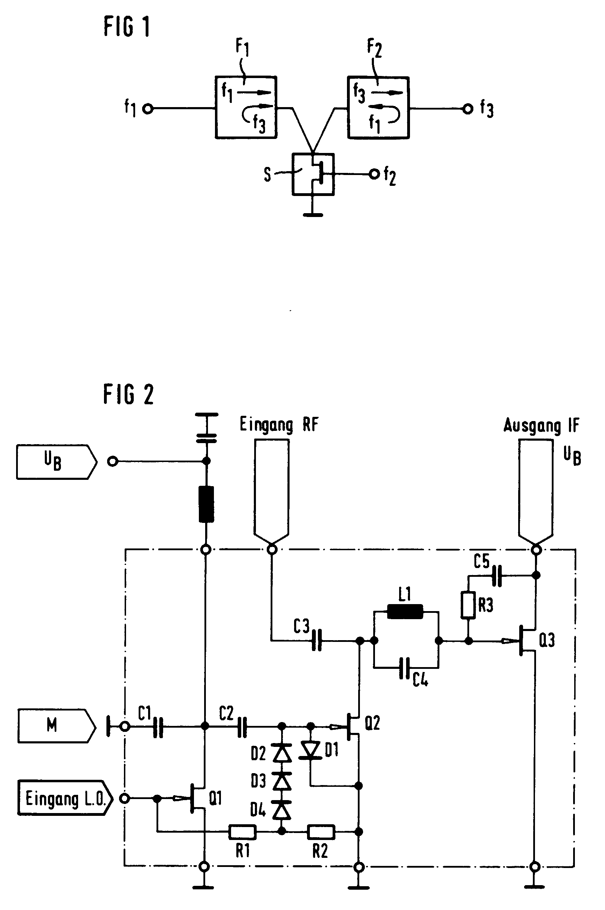

In FIG 1 ist die Funktion des Mischers der Anordnung wiedergegeben. Dabei erfolgt die Miscnung eines Eingangssignals bzw. zugeführten Nutzsignals der Frequenz f₁ mit einem Oszillatorsignal der Frequenz f₂ in eine gewünschte Frequenz f₃ =|f₁ + f₂| oder f₃ =|f₁ - f₂|, die als Zwischenfrequenz bezeichnet wird. Die Frequenzen stehen dabei auch für Frequenzbänder. Ein Schalterelement S, vorzugsweise ein Feldeffekttransistor, beispielsweise aber auch eine Diode usw., wird parallel zu dem signalführenden Pfad mit einer Steuerquelle der Oszillatorfrequenz f₂ hoch- und niederohmig geschaltet. Im signalzuführenden und im signalabführenden Teil des signalführenden Pfades ist dabei jeweils eine frequenzselektive Schaltung F₁ und F₂ eingefügt mit folgenden Eigenschaften: Im zuführenden Pfad: Durchlaß für f₁ und Sperrung für f₃ . Im abführenden Pfad: Durchlaß für f₃ und Sperrung für f₁ . Die Sperrung in den zweckmäßig als Filter ausgebildeten Schaltungen F₁ und F₂ erfolgt in Richtung zum Schalterelement S hochohmig reflektiv und ist in der FIG 1 durch einen Umkehrpfeil symbolisiert.

Die in FIG 2 dargestellte Gesamtschaltung der Anordnung zur Frequenzumsetzung umfaßt einen Mischer, einen geregelten L.O.-Treiberverstärker und einen ZF-Verstärker, die vorzugsweise in einem Halbleitersubstrat monolithisch integriert sind. Die Schaltung ist beispielsweise ausgelegt für eine Frequenzumsetzung eines Hochfrequenzsignals RF von ca. 1,2GHz in einer IF- bzw. ZF-Lage bis 200MHz bei einer Mischverstärkung G >10db, einem Mischrauschen F (SSB)<8db und einer Intermodulationsfestigkeit dIM > 60 dBc bei Pin = 2 x -15dBm. Der zugeführte L.O.-Pegel kann bei dieser Schaltung zwischen -10dBm und +13dBm liegen (Faktor 200), ohne daß die Funktion nennenswert beeinträchtigt wird. Die Leistungsaufnahme beträgt bei einer typischen Versorgungsspannung von U_{B} = 5V ca. 300mW. Die Betriebsspannung U_{B} kann bei dieser Schaltung in einem großen Bereich zwischen 2,5V und 7V schwanken. Der erreichbare Intermodulationsabstand dieses Mischers ist um den Faktor 100 bis 1000 besser als bei bisher bekannten MMIC-Mischern für die Consumerelektronik.

Der Mischer besteht aus dem passiven (ohne Betriebsstrom arbeitenden) Mischertransistor Q2 und den Frequenzfiltern. Im RF-Pfad als signalzuführenden Pfad befindet sich das Hochpaßfilter C3 und im signalabführenden bzw. IF-Pfad als Bandsperre die Induktivität L1 und die Kapazität C4. Die Diode D1 schützt das Gate des Feldeffekttransistors (Mischertransistor Q2) vor zu hohen Stromdichten in Flußrichtung.

Der L.O.-Treiberverstärker besteht aus dem Transistor Q1, dessen hohe Verstärkung mit einer hohen Steilheit durch eine große Gateweite erreicht wird. Das verstärkte L.O.-Signal steuert über C2 das Gate des Mischertransistors Q2 (Schalterbetrieb).
Die Summe der kapazitiven Belastungen am Drain des Transistors Q2 wird mit einer externen Induktivität L kompensiert, welche die Induktivität des Gehäuseanschlusses berücksichtigt. Der optional auf die Masse M anschließbare Kondensator C1 dient zur Verkleinerung der externen Induktivität L.

Die Begrenzer- und Regelschaltung, bestehend aus den Dioden D2, D3, D4 und den Widerständen R2, R1 begrenzt das mit dem Transistor Q1 verstärkte L.O.-Signal einerseits; die damit ebenfalls erzeugte negative Spannung am Widerstand R2, regelt andererseits über den Widerstand R1 das Gate von Transistor Q1 so weit ab, daß über einen weiten L.O.-Pegelbereich das Gate des Mischertransistors Q2 optimal angesteuert wird und gleichzeitig eine Minimierung des Stromverbrauchs der Gesamtschaltung erreicht wird.

Der IF- bzw. ZF-Verstärker besteht aus einem mit dem Widerstand R3 widerstandsgegengekoppelten Transistor Q3, um den Eingang und Ausgang niederohmig zu halten (75 Ohm bis 100 Ohm). Der integrierte DC-Trennkondensator C5 kann durch einen optionalen externen Kondensator vergrößert werden, womit der niederohmige Eingang in den IF-Verstärker zu kleineren Frequenzen hin erweitert werden kann.

## Patentansprüche

1. Anordnung zur Frequenzumsetzung eines Eingangssignals der Frequenz f₁ mit einem Oszillatorsignal der Frequenz f₂ zu einem Zwischenfrequenzsignal f₃,
bei der parallel zu einem signalführenden Pfad ein Schalterelement (S) geschaltet ist, das mit einer Steuerquelle der Oszillatorfrequenz f₂ hoch- und niederohmig geschaltet wird, bei der in einem signalzuführenden Pfad des signalführenden Pfades eine frequenzselektive Schaltung (F₁) eingefügt ist, mit den Eigenschaften, Durchlass für die Frequenz f₁ und sperrung für die Frequenz f₃ und
bei der in einem signalabführenden Pfad des signalführenden Pfades eine weitere frequenzselektive Schaltung (F₂) eingefügt ist, mit den Eigenschaften, Durchlass für die Frequenz f₃ und Sperrung für die Frequenz f₁,
**dadurch gekennzeichnet,** dass zwischen der Steuerquelle und dem Schalterelement (S) ein L.O.-Treiberverstärker (Q1) und eine Begrenzer- und Regelschaltung (D2,D3,D4;R1,R2) zur Begrenzung eines L.O.-Signals und zum Abregeln des L.O. Treiberverstärkers vorgesehen ist, sodaß das Schalterelement optimal angesteuert wird.

2. Anordnung gemäß Anspruch 1, **dadurch gekennzeichnet,** dass das Schalterelement (S) ein Mischertransistor (Q2), insbesondere ein Feldeffekttransistor ist.

3. Anordnung gemäß Anspruch 1 oder 2, **dadurch gekennzeichnet,** dass der L.O.-Treiberverstärker einen Transistor (Q1) aufweist und dass die Begrenzer- und Regelschaltung drei seriell verschaltete Dioden (D2, D3, D4) und zwei Widerstände (R1, R2) aufweist, die im Betrieb der Anordnung einer-seits ein vom L.O.-Treiberverstärker verstärktes L.O.-Signal begrenzt und andererseits den Transistor (Q1) so abregelt, dass der Mischertransistor (Q2) optimal angesteuert wird und gleichzeitig eine Minimierung des Stromverbrauchs der Anordnung erreicht wird.

4. Anordnung gemäß einem der Ansprüche 1 bis 3, **dadurch gekennzeichnet,** dass im signalabführenden Pfad ein ZF-Verstärker vorgesehen ist.

5. Anordnung gemäß Anspruch 4, **dadurch gekennzeichnet,** dass der ZF-Verstärker einen widerstandsgegengekoppelten weiteren Transistor (Q3) aufweist.

6. Anordnung nach einem der Ansprüche 1 bis 5, **dadurch gekennzeichnet,** dass die Anordnung auf einem Halbleitersubstrat monolithisch integriert ist.

## Claims

1. Arrangement for the frequency conversion of an input signal having the frequency f₁ with an oscillator signal having the frequency f₂ to form an intermediatefrequency signal f₃,
in which a switch element (S) is connected in parallel with a signal-carrying path, which switch element is switched to have a high and low impedance by a control source having the oscillator frequency f₂,
in which a frequency-selective circuit (F₁) is inserted in a signal-feeding path of the signal-carrying path, with the following properties: transmission for the frequency f₁ and blocking for the frequency f₃, and in which a further frequency-selective circuit (F₂) is inserted in a signal-emitting path of the signal-carrying path, with the following properties: transmission for the frequency f₃ and blocking for the frequency f₁,
characterized in that there are provided between the control source and the switch element (S) an L.O. driver amplifier (Q1) and a limiter and regulating circuit (D2, D3, D4; R1, R2) for limiting an L.O. signal and for regulating the L.O. driver amplifier, with the result that the switch element is driven in an optimum manner.

2. Arrangement according to Claim 1, characterized in that the switch element (S) is a mixer transistor (Q2), in particular a field-effect transistor.

3. Arrangement according to Claim 1 or 2, characterized in that the L.O. driver amplifier has a transistor (Q1), and in that the limiter and regulating circuit has three diodes (D2, D3, D4) connected in series and two resistors (R1, R2), which circuit, during operation of the arrangement, on the one hand limits an L.O. signal amplified by the L.O. driver amplifier and, on the other hand, regulates the transistor (Q1) in such a way that the mixer transistor (Q2) is driven in an optimum manner and, at the same time, the current consumption of the arrangement is minimized.

4. Arrangement according to one of Claims 1 to 3, characterized in that an IF amplifier is provided in the signal-emitting path.

5. Arrangement according to Claim 4, characterized in that the IF amplifier has a further transistor (Q3) having resistive negative feedback.

6. Arrangement according to one of Claims 1 to 5, characterized in that the arrangement is monolithically integrated on a semiconductor substrate.

## Revendications

1. Dispositif pour conversion de fréquence d'un signal d'entrée de fréquence f₁ avec un signal d'oscillateur de fréquence f₂ en un signal de fréquence intermédiaire f₃,
dans lequel est branché en parallèle au trajet conducteur du signal un élément interrupteur (S), branché à haute et à basse impédance à une source de commande de la fréquence d'oscillateur f₂,
dans lequel un circuit sélectif en fréquence (F₁) est intégré dans un trajet d'alimentation du signal du trajet conducteur du signal, présentant les propriétés de passage pour la fréquence f₁ et de blocage pour la fréquence f₃, et
dans lequel est intégré dans un trajet d'évacuation du signal du trajet conducteur du signal un autre circuit sélectif en fréquence (F₂), présentant les propriétés de passage pour la fréquence f₃ et de blocage pour la fréquence f₁,
**caractérisé en ce que**
entre la source de commande et l'élément interrupteur (S) est prévu un amplificateur pilote L.O. (Q1) et un circuit limiteur et régulateur (D2, D3, D4; R1, R2) destiné à limiter un signal L.O. et à réguler vers la baisse l'amplificateur pilote L.O. si bien que l'élément interrupteur est commandé de manière optimale.

2. Dispositif selon la revendication 1, caractérisé en ce que l'élément interrupteur (S) est un transistor mélangeur (Q2), notamment un transistor à effet de champ.

3. Dispositif selon la revendication 1 ou 2, caractérisé en ce que l'amplificateur pilote L.O. présente un transistor (Q1) et en ce que le circuit limiteur et régulateur présente trois diodes montées en série (D2, D3, D4) et deux résistances (R1, R2), qui, lorsque le dispositif fonctionne, limite d'une part un signal L.O. amplifié par l'amplificateur pilote L.O. et d'autre part régule vers la baisse le transistor (Q1) de telle sorte que le transistor mélangeur (Q2) est commandé de manière optimale et que parallèlement la consommation de courant du dispositif est minimisée.

4. Dispositif selon l'une des revendications 1 à 3, caractérisé en ce qu'un amplificateur F1 est prévu dans le trajet d'évacuation du signal.

5. Dispositif selon la revendication 4, caractérisé en ce que l'amplificateur F1I comporte un autre transistor (Q3) contrecouplé par résistance.

6. Dispositif selon l'une des revendications 1 à 5, caractérisé en ce que le dispositif est intégré de manière monolithique sur un substat semi-conducteur.
